Europäisches Patentamt

European Patent Office

Office européen des brevets

(19)

(11) Publication number: **0 147 135**
**A2**

# EUROPEAN PATENT APPLICATION

(21) Application number: **84308680.2**

(22) Date of filing: **13.12.84**

(51) Int. Cl.⁴: **H 03 K 17/08**

(30) Priority: **27.12.83 JP 247267/83**

(43) Date of publication of application:
**03.07.85 Bulletin 85/27**

(84) Designated Contracting States:
**DE FR GB**

(71) Applicant: **FUJI ELECTRIC CO., LTD.**
**1-1, Tanabeshinden, Kawasaki-ku**
**Kawasaki-shi Kanagawa 210(JP)**

(72) Inventor: **Kuroki, Kazuo**
**Ishihata 815-38 Mizuho-cho, Nishitama-gun**
**Tokyo 190-12(JP)**

(74) Representative: **Gordon, Martin et al,**
**G.F. Redfern & Company Marlborough Lodge 14**
**Farncombe Road**
**Worthing West Sussex, BN11 2BT(GB)**

(54) Switching Transistor Arrangement.

(57) A switching transistor (2) has its emitter connected to one side of a reactor (5) (inductance L) whose other side is connected to one side of a diode arrangement (6) whose other side is connected to the base of the transistor (2). Thus when the transistor is switched off, decay of the current through the transistor, and thus in the reactor (5), generates an e.m.f. across the reactor (5) which is supplied via the diode arrangement (6) to the base of the transistor. By suitable construction of the diode arrangement (6) a desired decay characteristic can be obtained to limit current surge into a snubber circuit (3) associated with the switching transistor.

Fig. 3

EP 0 147 135 A2

## "SWITCHING TRANSISTOR ARRANGEMENT"

This invention relates to a control circuit for a switching transistor i.e. a transistor arranged to provide a switching action.

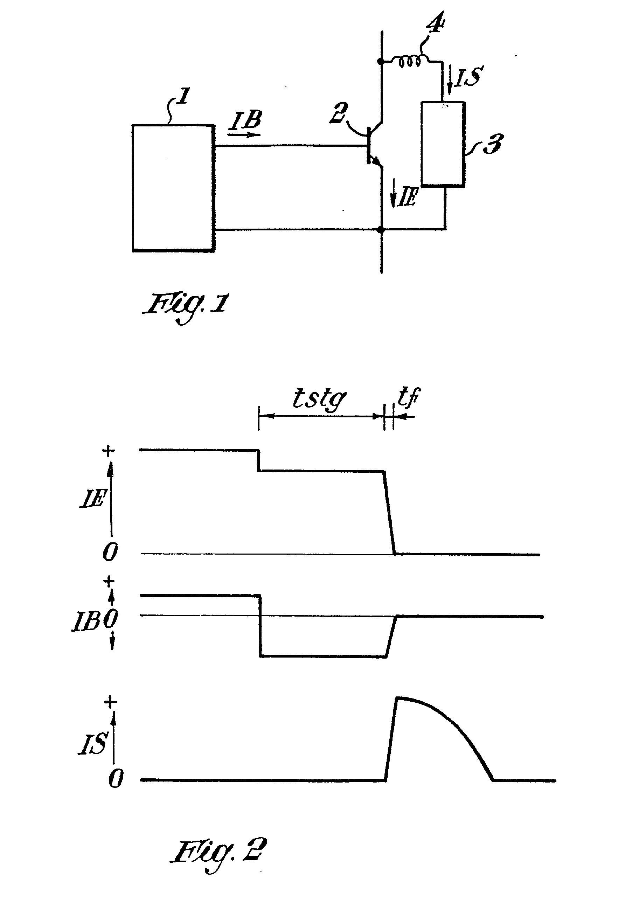

Referring to Fig. 1 of the accompanying drawings, in a conventional circuit for switching an npn transistor on and off. an output of a base driving unit 1 is connected across the base and emitter of the switching transistor 2, whereas a snubber circuit 3 is connected across the collector and emitter of the transistor 2. The inductor 4 represents the distributed (transmission line) inductance along the length of a line leading to the snubber circuit 3.

Fig. 2 shows a waveform in each portion of the circuit thus arranged, wherein the transistor 2 is switched on when a positive current IB is supplied from the base driving unit 1 to the base of the transistor 2 and wherein the transistor is switched off after storage time (tstg) and decay time (tf) when the current reverses and is supplied from the emitter to the base.

In the switching circuit thus arranged, the energy stored in the distributed inductance while the transistor 2 is held on is applied to the transistor 2 as a spike voltage. In order to reduce the voltage to below an allowable upper limit, the snubber circuit 3 comprising a capacitor, a resistor, a diode, etc. is connected across the collector and emitter of the transistor 2. However, since the decay time (tf) of the transistor in this arrangement is extremely short (tf<1µ sec), the rise rate (di/dt) of the current flowing into the snubber circuit 3 when the transistor 2 is switched off becomes very high and consequently the inductance of the snubber circuit 3 and along the length of the line leading to the snubber circuit 3 must be made extremely small.

On the other hand, since a plurality of parallel transistors are used to cause a large current to flow and stop flowing in an apparatus of large current capacity, the apparatus becomes structurally large in size and it becomes very complicated in construction to reduce the inductance of the snubber circuit 3 and along the length of the line leading to the snubber circuit 3. As a result the apparatus becomes more difficult to maintain and also becomes expensive because the components must be such that their inductance is minimized. Another disadvantage is that, since the generation of noise will also increase if a large current is made to flow and then stop flowing at high speed, the noise will complicate the measures taken against such noise thus increasing the cost.

It is an object of the present invention to provide a switching transistor arrangement having a controlled current decay characteristic so as to avoid excessive size of the apparatus and problems with maintenance and noise.

According to the present invention there is provided a switching transistor arrangement comprising a switching transistor, a reactor having one side connected to the emitter of the switching transistor and the other side connected to one side of a diode arrangement whose other side is connected to the base of the switching transistor such that, in operation, when said switching transistor is switched off, the electromotive force thereby generated across the reactor is applied via the diode arrangement to the base of the switching transistor in such a way as to provide a controlled decay characteristic of the current through the transistor.

An embodiment of the invention will now be described, by way of example, with reference to the accompanying drawings in which:-

Fig. 1 is a block circuit diagram of a conven-

0147135

tional switching transistor arrangement;

Fig. 2 is a set of waveforms illustrating the operation of the arrangement shown in Fig. 1;

Fig. 3 is a block circuit diagram of a switching transistor arrangement embodying this invention; and

Fig. 4 is a set of waveforms illustrating the operation of the arrangement shown in Fig. 3.

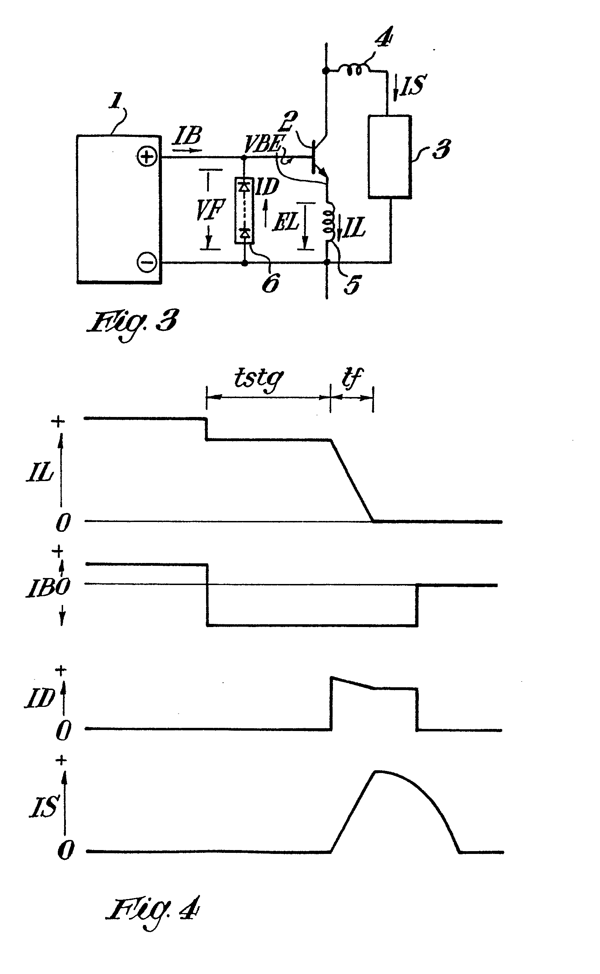

Referring now to Fig. 3, like reference signs to those used in Fig. 1 designate like or corresponding components. In other words, the arrangement shown in Fig. 3 includes a switching transistor 2, a base driving unit 1 connected across the base and emitter of the transistor 2, a snubber circuit 3 connected across the collector and emitter and inductor 4 representing distributed inductance.

In addition to the above-described arrangement, a reactor 5 has one terminal connected in series with the emitter of the transistor 2 and a diode arrangement 6 is connected between the other terminal of the reactor 5 and the base of the transistor 2. The diode arrangement 6 may comprise only one diode or may comprise a plurality of diodes connected in series. Moreover, the direction (polarity) in which the diode arrangement 6 is inserted should be such that the electromotive force due to the reactor 5, generated as the current decreases when the transistor 2 is switched off, is applied to the base of the transistor 2 through the diode arrangement 6.

The operation of the arrangement shown in Fig. 3 will now be described. Referring to Fig. 4, an operational waveform is shown of each portion of the circuit wherein the transistor 2 is held on when positive current is supplied from the base driving unit 1 to the transistor 2 and wherein the collector current of the transistor 2 starts decreasing after the storage time (tstg) and decay time when the current is supplied from the emitter to base.

At this time, because the curret IL in the reactor 5 starts decreasing, the electromotive force EL is induced across the reactor 5 such that the terminal of the reactor 5 connected to the emitter of the transistor 2 becomes negative and the other terminal becomes positive. The electromotive force EL is given by:-

$$EL = L \cdot dIL/dt$$

where L is inductance of the reactor 5; and dIL/dt is the rate of change of current. Assuming that the forward voltage of the diode arrangement 6 is VF and the voltage across the base and emitter of the transistor 2 is VBE while the base driving unit 1 supplies a constant current -IB (inverse bias base current), the output current -IB of the base driving unit 1 under the condition EL<(VBE + VF) will follow the path (-) terminal→ reactor 5→ emitter→ base → (+) terminal, acting to shorten the decay time (tf) of the collector current and cause EL to increase.

Under the condition EL>(VBE + VF) the output current of the base driving unit 1 will follow the path (-) terminal→ diode arrangement→ (+) terminal. At this time, the current from the reactor 5 is conducted to the base of the transistor 2 through the diode arrangement 6, acting to prolong the decay time (tf) of the collector current and cause EL to decrease.

Based on this, the current IL in the reactor shows such a decay characteristic as to satisfy the condition of EL ⇆ VBE + VF. Since EL = L · dIL/dt, the decay characteristic (dIL/dt) may be adjusted by changing the forward voltage VF of the diode arrangement 6 or the inductance of the reactor, provided that VBE is substantially constant.

As above described, since the circuit for interrupting the operation of a switching transistor is so arranged that the electromotive force, induced when the current in the reactor starts decreasing, is supplied to the base of the transistor through the diode arrangement, it has become possible to maintain the storage time at the time of switching the transistor off and adjust the decay time (tf). As a result, the rate of change (di/dt) of the current flowing into a snubber circuit for controlling over-voltage can be minimized, so that problems of excessive size imposed on the snubber circuit can be eased and maintenance is facilitated. The amount of noise generated is reducible because the current decay rate (-di/dt) at the time of switching the transistor off can be minimized as is the cost of measures needed to combat noise.

Thus the embodiment described above provides a switching transistor arrangement comprising a switching transistor (2), a reactor (5) having one side connected to the emitter of the switching transistor (2) and the other side connected to one side of a diode arrangement (6) whose other side is connected to the base of the switching transistor (2) such that, in operation, when said switching transistor (2) is switched off, the electromotive force thereby generated across the reactor (5) is spplied via the diode arrangement (6) to the base of the switching transistor (2) in such a way as to provide a controlled decay characteristic of the current through the transistor (2).

CLAIMS:-

1.   A switching transistor arrangement comprising a switching transistor, a reactor having one side connected to the emitter of the switching transistor and the other side connected to one side of a diode arrangement whose other side is connected to the base of the switching transistor such that, in operation, when said switching transistor is switched off, the electromotive force thereby generated across the reactor is applied via the diode arrangement to the base of the switching transistor in such a way as to provide a controlled decay characteristic of the current through the transistor.

2.   A switching transistor arrangement according to claim 1 wherein said reactor and diode arrangement are arranged to maintain said electromotive force substantially equal to the sum of the base-emitter voltage and the forward voltage of the diode arrangement.

3.   A switching transistor arrangement according to claim 2 wherein said diode arrangement includes one or more series-connected diodes selected to provide a desired decay characteristic.

Fig. 1

Fig. 2

0147135

*Fig. 3*

*Fig. 4*